# EUROPEAN PATENT APPLICATION

(11) **EP 2 753 161 A1**
(43) Date of publication of application: **09.07.2014**
(21) Application number: 13838379.9
(22) Date of filing: 19.09.2013
(51) Int. Cl.: H05K 9/00, H01F 17/06, H01F 27/02

(54) **FERRITE CLAMP**

(30) Priority: 19.09.2012 JP 2012205624; 03.12.2012 JP 2012264517
(71) Applicant: Kitagawa Industries Co., Ltd., Inazawa-shi, Aichi 4928446 (JP)
(72) Inventor: KAWAI, Hideharu, Inazawa-shi Aichi 492-8446 (JP); KOKAJI, Satoyo, Toyota-shi Aichi 471-8571 (JP); NAITO, Takayuki, Toyota-shi Aichi 471-8571 (JP)
(74) Representative: Kocher, Mark Werner
(86) International application number: PCT/JP2013/075329
(87) International publication number: WO 2014/046194

(57) **Abstract**

A ferrite clamp includes: a storage case capable of storing a magnetic body and including a pair of separable storage portions; and a pair of electric-wire insertion holes formed in one side surface and the other side surface of the storage case respectively, wherein each of the pair of storage portions includes a protrusion piece and a concave portion, the protrusion piece and concave portion are positioned such that, when the pair of storage portions are assembled together, the protrusion piece disposed in one of the storage portions is fitted into the concave portion formed in the other storage portion, and the protrusion piece disposed in the other storage portion is fitted into the concave portion formed in the one storage portion.

## Description

### CROSS-REFERENCE TO RELATED APPLICATION

This international application claims the right of priority based on Japanese Patent Application No. 2012-205624 filed to the Japan Patent Office on September 19, 2012 and Japanese Patent Application No. 2012-264517 filed to the Japan Patent Office on December 3, 2012. The entire contents of Japanese Patent Application Nos. 2012-205624 and 2012-264517 are incorporated into this international application by reference.

### TECHNICAL FIELD

The present invention relates to ferrite clamps.

### BACKGROUND ART

Conventionally, a ferrite clamp has been used to remove electric noise resulting from a current flowing in a cable. The ferrite clamp has a structure of two divided members. In use, the two members are assembled together to attach to a cable or a wire harness.

The two members are generally joined at one end by a hinge. The other ends of the two members are respectively fixed by lock mechanism (Patent Literature 1). In another type of a ferrite clamp, the two assembled members, once assembled, cannot be separated from each other unless the two members are broken (Patent Literature 2).

### PRIOR ART DOCUMENTS

### PATENT DOCUMENTS

Patent Document 1: JP-A-2011-071263
Patent Document 2: JP-U-3045426

### SUMMARY OF THE INVENTION

### PROBLEMS TO BE SOLVED BY THE INVENTION

From the viewpoint of maintenance, it is preferred to separate (or release) two members constituting a ferrite clamp so that the ferrite clamp can be removed from the cable or the wire harness. However, in case that a ferrite clamp is attached to the cable or the wire harness for EMC in an important unit in an EV (electric vehicle), HEV (hybrid electric vehicle), and PHEV (plug-in hybrid electric vehicle), for example, there is the possibility that various problems are caused by the configuration in which general users can easily remove a ferrite clamp.

One aspect of the present invention is to provide a ferrite clamp that is removable but difficult to remove for general users.

### MEANS FOR SOLVING THE PROBLEMS

A ferrite clamp according to one aspect of the present invention includes: a storage case capable of storing a magnetic body and including a pair of separable storage portions; and a pair of electric-wire insertion holes formed in one side surface and the other side surface of the storage case respectively, wherein each of the pair of storage portions includes a protrusion piece and a concave portion, the protrusion piece and concave portion are positioned such that, when the pair of storage portions are assembled together, the protrusion piece disposed in one of the storage portions is fitted into the concave portion formed in the other storage portion, and the protrusion piece disposed in the other storage portion is fitted into the concave portion formed in the one storage portion.

The ferrite clamp of the present invention is removable but difficult to remove for general users.

The protrusion piece has preferably an arrowhead-shaped falling inhibition portion to inhibit the protrusion piece from falling off from the concave portion. The provision of the arrowhead-shaped falling inhibition portion further enhances the difficulty of removing for general users. In addition, the ferrite clamp of the present invention preferably includes a locking portion to lock the falling inhibition portion in the protrusion piece fitted into the concave portion. The provision of the locking portion further enhances the difficulty of removing for general users.

The ferrite clamp of the present invention preferably includes an electric-wire fixing portion that is extended outward in an axial direction of the pair of electric-wire insertion holes from at least one side wall of each of the pair of storage portions. By sandwiching the electric wire by the two opposed electric-wire fixing portions and tightly binding the same with a binding band or a tape, the ferrite clamp can be fixed easily and firmly to the electric wire. In addition, the ferrite clamp can be attached or detached with the electric-wire fixing portion held by hand, thereby improving workability.

A holding piece for holding the pair of storage portions in closed state may be disposed on a side wall of each of the storage portions. The holding piece may be disposed on the both side walls of the storage portions. By configuring the ferrite clamp in this manner, the joint surfaces of the magnetic bodies stored in the pair of storage portions are not separated from each other. Thus, both of the divided magnetic bodies form and maintain a closed magnetic path at any time, thereby achieving a reliable noise absorbing effect.

The ferrite clamp of the present invention is preferably made of PA11 (nylon 11). In this case, PA11 has a low water absorption rate and thus the ferrite clamp becomes higher in dimension accuracy. In addition, PA11 has high heat resistance and high resistance to calcium chloride. Thus, the ferrite clamp can be placed outside the vehicle chamber. Further, PA11 is a polyamide-based resin as with PA66, and does not require a special mold structure. The ferrite clamp can be therefore manufactured by the same mold as that of PA66.

### BRIEF DESCRIPTION OF THE DRAWINGS

- Fig. 1: is an explanatory diagram illustrating a ferrite clamp of one example of the present invention that is attached to an electric wire (closed state).
- Fig. 2: is an explanatory diagram illustrating the open ferrite clamp of one example of the present invention.
- Fig. 3A: is an explanatory diagram illustrating the open ferrite clamp of one example of the present invention.
- Fig. 3B: is an explanatory diagram illustrating the closed ferrite clamp of one example of the present invention.
- Fig. 4: is a perspective diagram illustrating a configuration of a storage portion constituting the ferrite clamp of one example of the present invention.
- Fig. 5: is an explanatory diagram illustrating a configuration of the storage portion as seen from D1 direction illustrated in Fig. 4.
- Fig. 6: is an explanatory diagram illustrating a configuration of the storage portion as seen from D2 direction illustrated in Fig. 4.
- Fig. 7: is an explanatory diagram illustrating a configuration of the storage portion as seen from D3 direction illustrated in Fig. 4.
- Fig. 8: is an explanatory diagram illustrating a configuration of the storage portion as seen from D4 direction illustrated in Fig. 4.
- Fig. 9: is a cross-sectional view of Fig. 8 as taken along line IX-IX.
- Fig. 10: is a perspective diagram illustrating a configuration of a ferrite piece for use in the ferrite clamp of one example of the present invention.
- Fig. 11: is a perspective diagram illustrating a configuration of the storage portion storing the ferrite piece illustrated in Fig. 10.
- Fig. 12: is an imaginary diagram illustrating phenomena that may occur when external force is applied to an electric-wire fixing portion of the ferrite clamp.
- Fig. 13: is an explanatory diagram illustrating the used state of the ferrite clamp of one example of the present invention.
- Fig. 14: is a perspective diagram illustrating the storage portion in a ferrite clamp of a modification example of the present invention.
- Fig. 15: is an explanatory diagram illustrating the used state of the ferrite clamp illustrated in Fig. 14.
- Fig. 16: is an explanatory diagram illustrating the used state of a ferrite clamp of another modification example of the present invention.

### EXPLANATION OF REFERENCE NUMERALS

1... Ferrite clamp, 3, 5... Storage portion, 3a, 5a...·Opening surface, 7... Storage case, 7a, 7b... Side surface, 9, 11... Electric-wire insertion hole, 13... Peripheral wall, 13a, 13b ... End portion, 15, 17... Side wall, 15a, 17a... Cut-out, 19... Biasing piece, 21... Protrusion portion, 23... Protrusion piece, 23a... Falling inhibition portion, 25... Engagement member, 25a ... Engagement main body portion, 25b, 25c... Leg portion, 27... Concave portion, 29... Electric-wire fixing portion, 31... Holding piece, 33... Holding piece engagement portion, 101... Electric wire, 103... Ferrite piece, 105... Electric-wire insertion groove, 107... Joint surfaces, 109... Engagement groove

### MODE FOR CARRYING OUT THE INVENTION

An embodiment of the present invention will be described with reference to the drawings.

### 1. Configuration of ferrite clamp 1

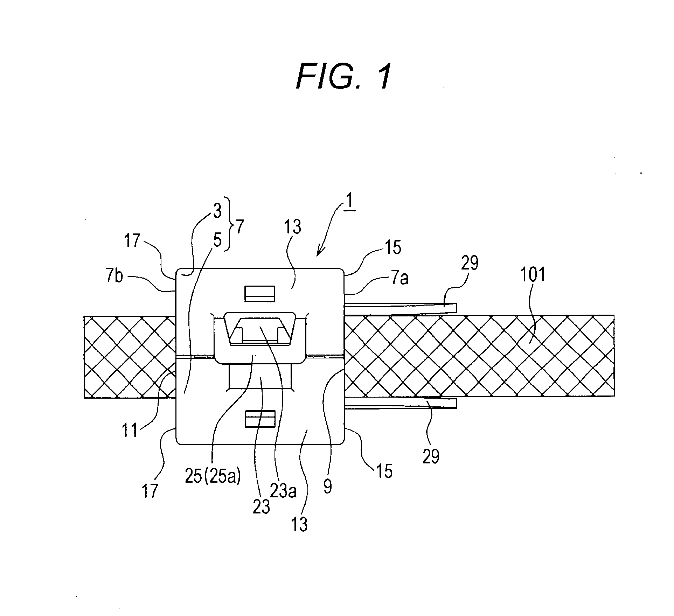

A ferrite clamp 1 includes a storage case 7 with a pair of separable storage portions 3 and 5 as illustrated in Figs. 1, 2, 3A, and 3B3. The storage case 7 has electric-wire insertion holes 9 and 11 for respectively inserting an electric wire 101 on one side surface 7a and the other side surface 7b. By inserting the electric wire 101 into the electric-wire insertion holes 9 and 11, the ferrite clamp 1 can be attached around the electric wire 101.

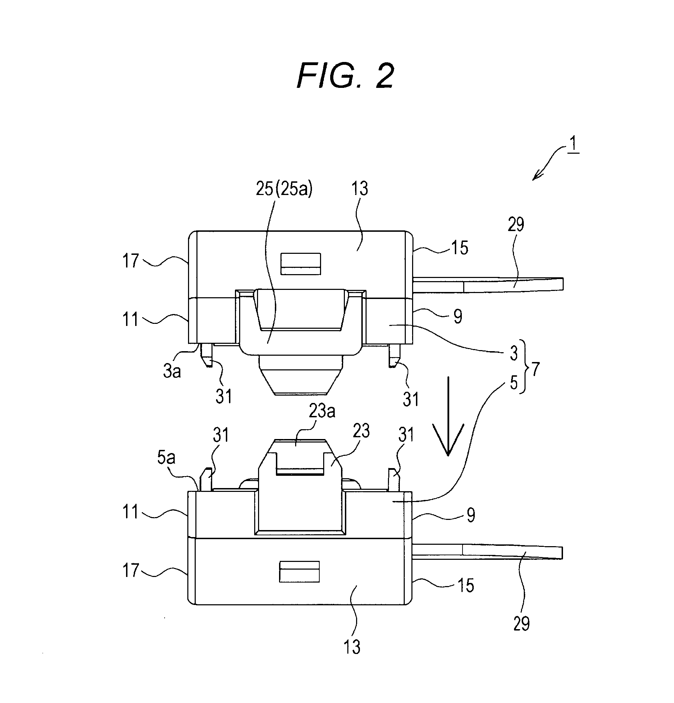

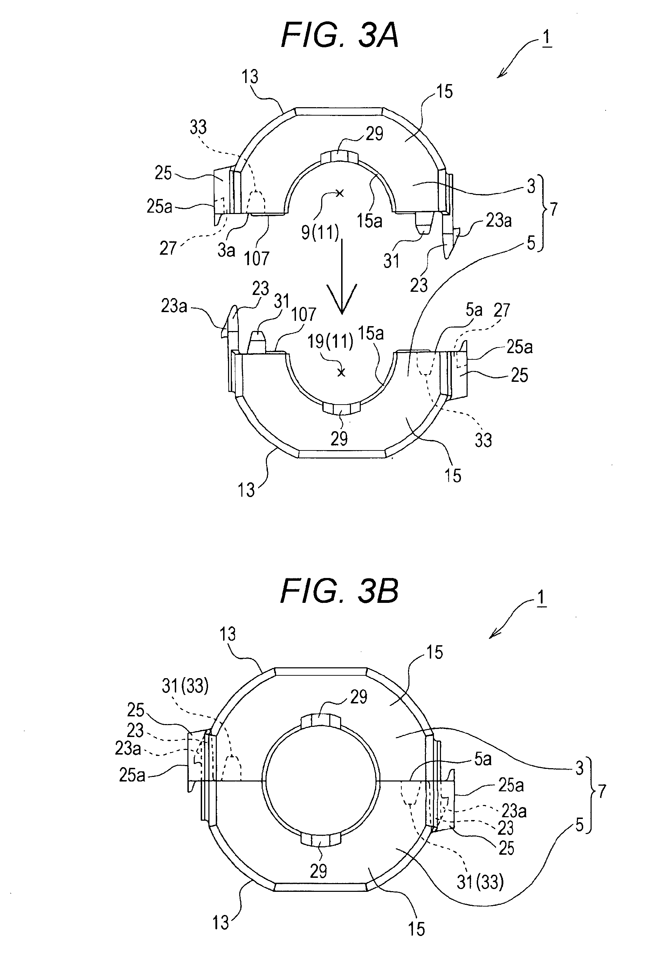

The ferrite clamp 1 can be in the state in which the storage portions 3 and 5 are separated as illustrated in Figs. 2 and 3A and the state in which the storage portions 3 and 5 are assembled together as illustrated in Figs. 1 and 3B. In the following description, the state illustrated in Figs. 2 and 3A will be referred to as open state of the ferrite clamp 1 and the state illustrated in Figs. 1 and 3B will be referred to as closed state of the ferrite clamp 1.

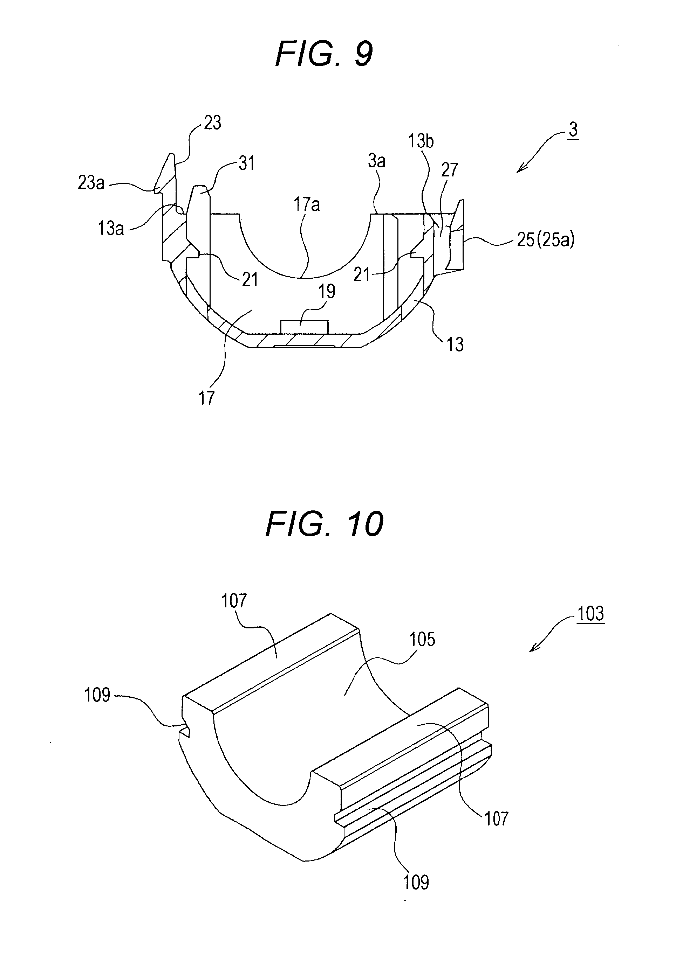

A pair of ferrite pieces 103 (refer to Fig. 10) are stored in the storage case 7. The ferrite piece 103 has the shape obtained by evenly dividing an annular body having a length in the axial direction (that is a cylinder) into two in the axial direction. The ferrite piece 103 has at a central portion thereof an electric-wire insertion groove 105 with a semicircular cross section formed in the axial direction (from the upper-right to lower-left side illustrated in Fig. 10). Joint surfaces 107 are formed on both sides of the electric-wire insertion groove 105 and equivalent to the divided surfaces by dividing into two as mentioned above. In addition, formed in the vicinity of the joint surfaces 107 on the outside surface of the ferrite piece 103 are engagement grooves 109 that engage protrusion portions 21 described later in the axial direction.

The storage portions 3 and 5 are integrally formed by synthetic resin (PA11). The storage portions 3 and 5 respectively can store the ferrite pieces 103. The storage portions 3 and 5 are identical in configuration. Thus, the storage portion 3 will be mainly described below.

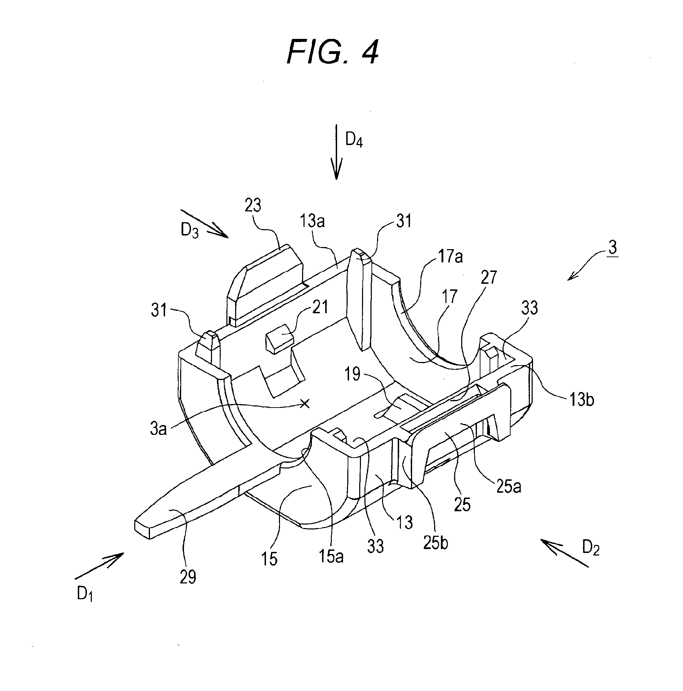

Figs. 4 to 9 illustrate the storage portion 3 from which the ferrite piece 103 is removed. The storage portion 3 has the shape obtained by evenly dividing a hollow circular cylinder into two in the axial direction. The divided surface of the storage portion 3 constitutes an opening surface 3a. That is, the storage portion 3 has a peripheral wall 13 equivalent to the peripheral surface of the foregoing circular cylinder, and side walls 15 and 17. The side walls 15 and 17 are provided on both sides of the peripheral wall 13 and are orthogonal to the peripheral wall 13. In the following description, the foregoing axial direction is referred to as axial direction of the storage portion 3. The storage portion 3 is configured such that the ferrite piece 103 can be taken in and out from the opening surface 3a side. The divided surface of the storage portion 5 constitutes an opening surface 5a.

As illustrated in Figs. 4, 8, and 9, a biasing piece 19 protruding in the upward direction in Fig. 4 is formed at a portion constituting a bottom surface of the peripheral wall 13 (at the central portion in the inside surface of the peripheral wall 13). When the ferrite piece 103 is stored in the storage portion 3, the biasing piece 19 biases the ferrite piece 103 in the upward direction in Fig. 4.

A pair of protrusion portions 21 and 21 protruding to the inside of the storage portion 3 is respectively formed in the vicinities of end portions 13a and 13b , which belong to the opening surface 3a, in the inside surface of the peripheral wall 13. Further, a protrusion piece 23 as a plate-like member protruding in a direction orthogonal to the opening surface 3a is disposed in an approximately middle of the end portion 13a, and an engagement member 25 is disposed in the vicinity of the other end portion 13b.

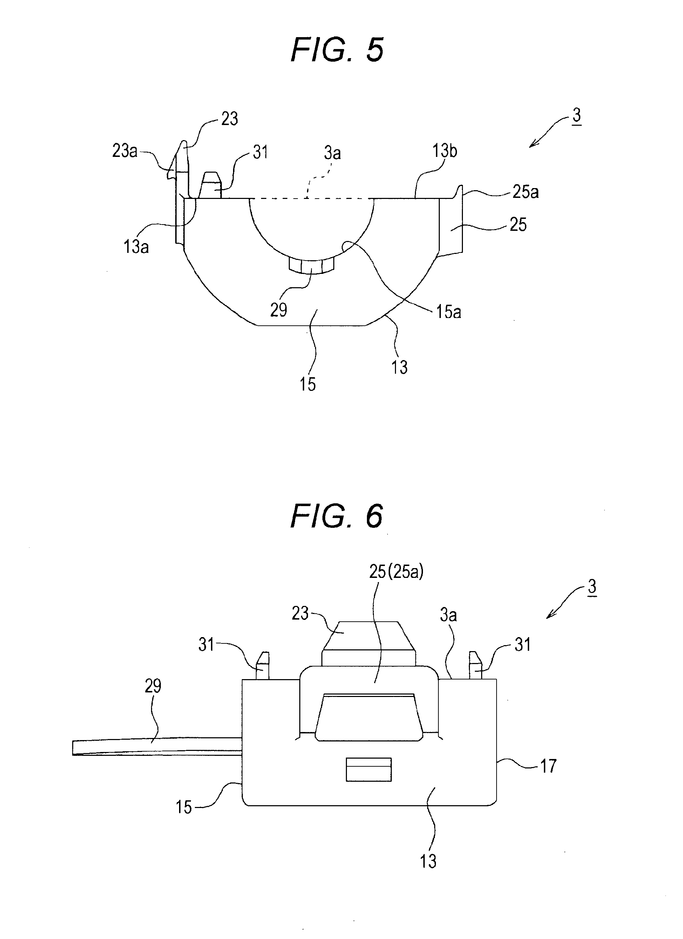

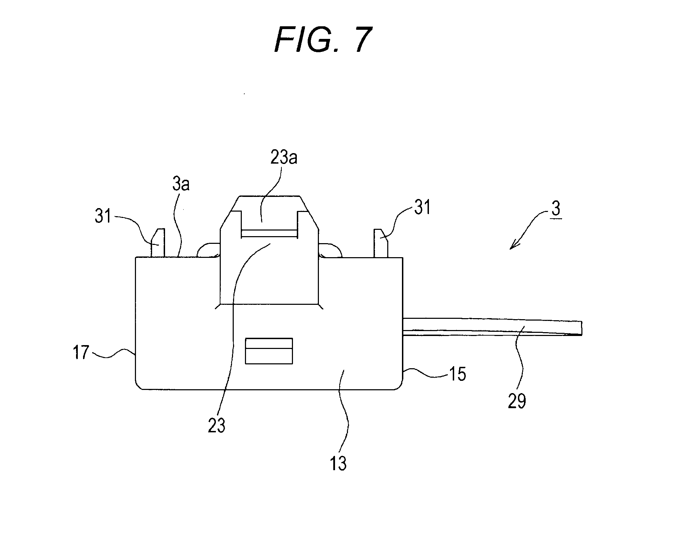

As illustrated in Figs. 5 and 9, the protrusion piece 23 includes an arrowhead-shaped falling inhibition portion 23a on the outside of a portion near a leading tip. In addition, as illustrated in Figs. 4 and 7, the leading tip of the protrusion piece 23 has a tapered shape (gradually narrower with increasing proximity to the leading tip) in both of width and thickness directions.

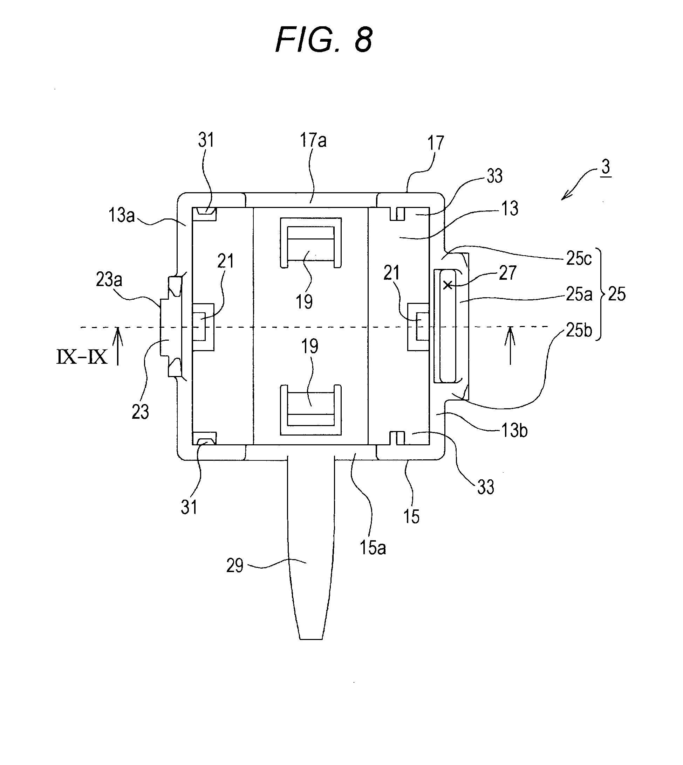

The engagement member 25 includes a plate-like engagement main body portion 25a opposed to the peripheral wall 13 and a pair of leg portions 25b and 25c. The pair of leg portions 25b and 25c connect the engagement main body portion 25a and the peripheral wall 13 at both ends of the engagement main body portion 25a. There is a gap between the engagement member 25 and a portion of the peripheral wall 13 opposed to the engagement member 25. When viewed from the direction orthogonal to the opening surface 3a, there is a space surrounded by the peripheral wall 13 and the engagement member 25 as illustrated in Fig. 8. The space will be hereinafter referred to as a concave portion 27. The concave portion 27 communicates from the opening surface 3a side (the upper side in Fig. 4) to the opposite side.

Approximately semicircular cut-outs 15a and 17a are formed in the side walls 15 and 17 at the opening surface 3a sides thereof. A plate-like electric-wire fixing portion 29 is disposed on the outside surface of the side wall 15. The electric-wire fixing portion 29 is extended from the center of a peripheral edge of the cut-out 15a in an outward direction (getting away from the storage portion 3 in the axial direction of the storage portion 3). The extending direction (longitudinal direction) of the electric-wire fixing portion 29 is parallel to the axial direction of the electric wire 101 when the ferrite clamp 1 is attached around the electric wire 101 as illustrated in Fig. 1.

Holding pieces 31 are disposed on the side walls 15 and 17 at the end portion 13a sides thereof. Holding piece engagement portions 33 are disposed on the side walls 15 and 17 at the end portion 13b sides thereof. The holding pieces 31 are convex portions that protrude in the direction orthogonal to the opening surface 3a. Each of the holding pieces 31 has the shape of a column with a cubic cross section and a tapered leading tip. The holding piece engagement portions 33 are concave portions into which the holding pieces 31 can be fitted. The axial direction of the concave portions is orthogonal to the opening surface 3a.

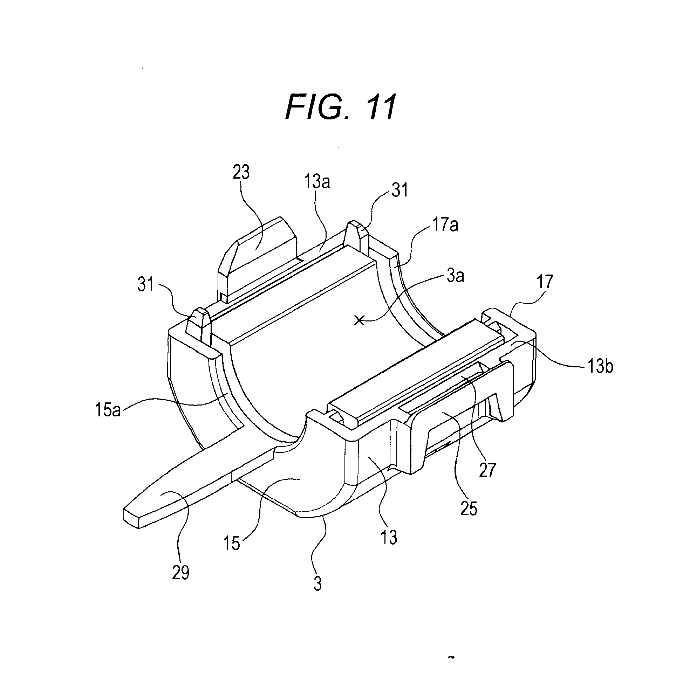

As illustrated in Fig. 11, when the ferrite clamp 1 is open, the storage portions 3 and 5 can store the ferrite pieces 103 therein. The ferrite pieces 103 are fitted in orientation such that the outside surfaces thereof (with the engagement grooves 109 formed) are opposed to the inside surfaces of the storage portions 3 and 5, and the axial direction of the electric-wire insertion groove 105 is aligned in the axial direction of the storage portions 3 and 5.

The ferrite pieces 103 of the same shape are stored in the storage portions 3 and 5. The stored ferrite pieces 103 do not easily fall off from the storage portions 3 and 5 due to the engagement of the engagement grooves 109 and the protrusion portions 21. When the ferrite clamp 1 is open, the pair of ferrite pieces 103 are not joined together or form an annular body.

When the ferrite clamp 1 is closed, the stored ferrite pieces 103 cannot be taken in or out. To hold the ferrite clamp 1 in closed state, as illustrated in Figs. 2, 3A, and 3B, the storage portions 3 and 5 are assembled together such that the opening surface 3a of the storage portion 3 and the opening surface 5a of the storage portion 5 are in contact with each other. At that time, the protrusion piece 23 of the storage portion 3 is fitted into the concave portion 27 of the storage portion 5. Further, the protrusion piece 23 of the storage portion 5 is fitted into the concave portion 27 of the storage portion 3. As illustrated in Figs. 1 and 3B, the protrusion piece 23 is fitted into the concave portion 27 until the falling inhibition portion 23a passes through the engagement main body portion 25a. As a result, the falling inhibition portions 23a are locked at the end portions of the engagement main body portions 25a. Thus, the protrusion pieces 23 are less prone to fall off from the concave portions 27. Specifically, the engagement main body portions 25a lock the falling inhibition portions 23a, thereby producing the function of making the protrusion pieces 23 less prone to fall off.

In addition, when the storage portions 3 and 5 are assembled together, the holding pieces 31 are fitted into the holding piece engagement portions 33, and thus the holding piece 31 of the storage portion 3 and the holding piece engagement portion 33 of the storage portion 5 engage with each other. Further, the holding piece 31 of the storage portion 5 and the holding piece engagement portion 33 of the storage portion 3 engage with each other. When fitting the holding pieces 31 into the holding piece engagement portions 33 or pulling the holding pieces 31 out of the holding piece engagement portions 33, the holding pieces 31 move relative to the holding piece engagement portions 33 in the direction orthogonal to the opening surface 3a.

As illustrated in Fig. 3B, when the ferrite clamp 1 is closed, the ferrite piece 103 stored in the storage portion 3 is biased toward the storage portion 5 by the storage portion 3 (in particular, the biasing piece 19). The ferrite piece 103 stored in the storage portion 5 is biased toward the storage portion 3 by the storage portion 5 (in particular, the biasing piece 19). As a result, the pair of ferrite pieces 103 forms an annular body by joining together the joint surfaces 107.

The region surrounded by the annular through hole, that is, by the two electric-wire insertion grooves 105 constitutes a through hole for insertion of the electric wire 101 into the annular body, which is formed by the pair of ferrite pieces 103. Each of the pair of ferrite pieces 103 is biased toward the other ferrite piece 103 by the biasing piece 19. The ferrite pieces 103 are therefore reliably joined together at the joint surfaces 107.

In addition, when the ferrite clamp 1 is closed, the side walls 15 of the storage portions 3 and 5 form a side surface 7a of the storage case 7. The side walls 17 of the storage portions 3 and 5 form a side surface 7b of the storage case 7.

There exist on the side surface 7a the electric-wire fixing portions 29 extended outward from the storage portions 3 and 5. In addition, formed on the side surface 7a is an circular hole (electric-wire insertion hole 9) by the cut-outs 15a of the storage portions 3 and 5. Also formed on the side surface 7b is a circular hole (electric-wire insertion hole 11) by the cut-outs 17a of the storage portions 3 and 5. The electric-wire insertion holes 9 and 11 are concentric to the through holes included in the pair of ferrite pieces 103 and have the same diameter as those of the through hole. The electric wire 101 can be therefore inserted into the through hole included in the pair of ferrite pieces 103 and the electric-wire insertion holes 9 and 11.

### 2. How to use the ferrite clamp 1

While the ferrite clamp 1 is open, the ferrite piece 103 is stored in each of the storage portions 3 and 5. Then, the electric wire 101 is placed in the electric-wire insertion groove 105 and the cut-outs 15a and 17a of either of the storage portions 3 and 5. Then, the ferrite clamp 1 is brought into a closed state. The ferrite clamp 1 is therefore attached around the electric wire 101 (refer to Fig. 1).

After that, to firmly fix the electric wire 101 and the ferrite clamp 1, as illustrated in Fig. 1, the electric wire 101 is sandwiched between the electric-wire fixing portion 29 of the storage portion 3 and the electric-wire fixing portion 29 of the storage portion 5. These electric-wire fixing portions 29 are tightly bound together by a binding band or a tape, for example.

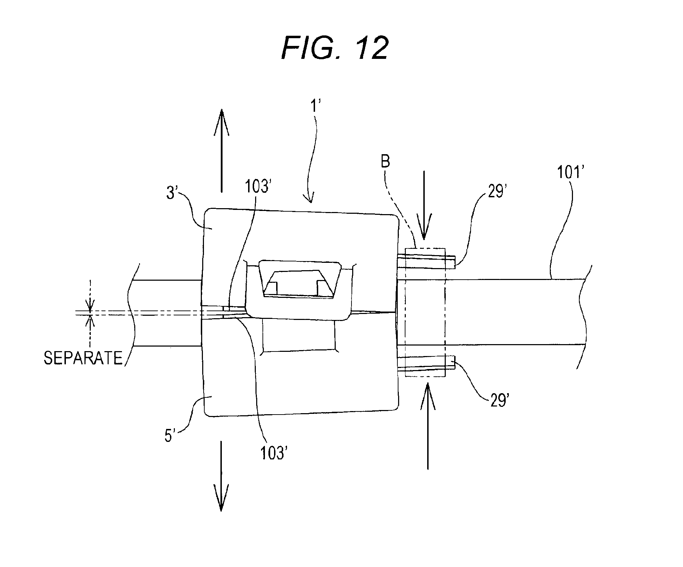

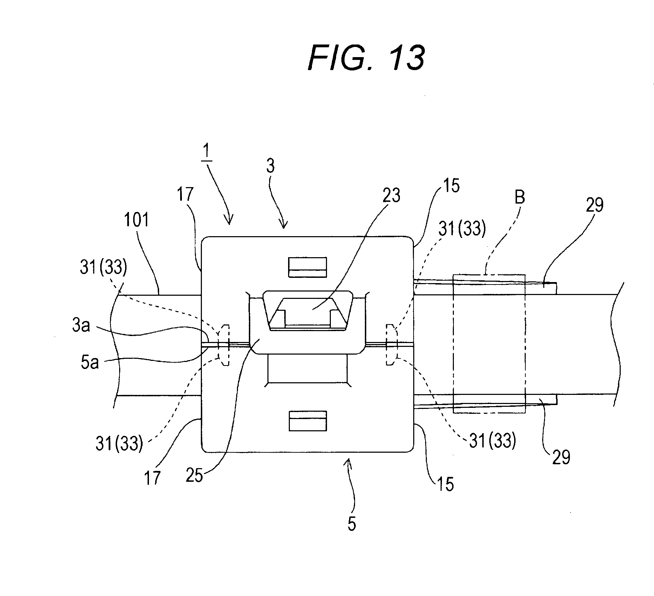

Descriptions will be given to the phenomenon possibly occurring when external force is applied to the electric-wire fixing portions of the ferrite clamps, with reference to Fig. 12 as a virtual diagram. As illustrated in Fig. 12, when electric-wire fixing portions 29' are tightly bound by a binding band B, the force acts on the side of a ferrite clamp 1' without the electric-wire fixing portions 29' such that a storage portion 3' and a storage portion 5' are separated from each other and ferrite pieces 103' are separated from each other. However, as illustrated in Fig. 13, the holding pieces 31 and the holding piece engagement portions 33 are disposed on the one side wall 15 provided with the electric-wire fixing portions 29 and the other side wall 17 as the opposite side. Thus, even if the foregoing force acts, the separation between the storage portion 3 and the storage portion 5 is suppressed. This maintains the state in which the opening surfaces 3a and 5a of the pair of storage portions 3 and 5 are brought together and closed. As a result, in the ferrite clamp 1, the joint surfaces 107 of the ferrite pieces 103 stored in the pair of storage portions 3 and 5 do not separate from each other. Thus, a closed magnetic path is constantly formed and maintained by the both ferrite pieces 103. The advantage of a noise absorber can be therefore reliably achieved.

The ferrite clamp 1 fixed to the electric wire 101 as described above suppresses propagation of noise (noise current) transferred through the electric wire 101 (obtaining the noise absorbing effect). The ferrite clamp 1 can be used for wire harnesses in vehicles (e.g., EVs, HEVs, PHEVs, and others), for example.

### 3. The advantage produced by the ferrite clamp 1

(1) The storage portions 3 and 5 can be separated from each other by disengaging the protrusion pieces 23 and the engagement members 25 of the closed ferrite clamp 1.

However, it is difficult for general users to separate the storage portions. This matter will be described with reference to Figs. 3A and 3B.

At the right part of Fig. 3A, the protrusion piece 23 is on the upper side and the engagement member 25 is on the lower side. Meanwhile, at the left part of Fig. 3A, the protrusion piece 23 is on the lower side and the engagement member 25 is on the upper side.

In general, the protrusion piece 23 and the engagement member 25 are disengaged by inserting a tool or the like from a specific direction. As described above, the position relationship between the protrusion piece 23 and the engagement member 25 is reversed between the right and left parts of Fig. 3A. Thus, at least on one side, a tool or the like can be hardly inserted from a specific direction to disengage the protrusion piece 23 and the engagement member 25.

For example, suppose that the ferrite clamp 1 is used in an engine room of a vehicle in which the space above the ferrite clamp 1 is opened. In addition, at the right part of Fig. 3B, suppose that a tool can be inserted from top down to disengage the protrusion piece 23 and the engagement member 25. In this case, at the left part of Fig. 3B, the positional relationship between the protrusion piece 23 and the engagement member 25 is reversed from that at the right part of the same. Thus, the protrusion piece 23 and the engagement member 25 can be hardly disengaged by inserting a tool from top. Needless to say, a tool can be hardly inserted from below into the ferrite clamp 1 stored in the engine room.

Hence, in the ferrite clamp 1, the protrusion piece 23 and the engagement member 25 can be hardly disengaged at least on one side. Thus, it is not easy for general users to separate the storage portions 3 and 5 (that is, remove the open ferrite clamp 1 from the wire harness).
(2) The ferrite clamp 1 is made of PA11 with a low water absorption rate, and thus has a high dimension accuracy (stable in dimensions). Thus, the ferrite clamp 1 can keep constant the fit strength of the storage portions 3 and 5. Therefore, when the ferrite clamp 1 is used in a vehicle, for example, it is possible to maintain the tendency of the storage portions 3 and 5 to fall off on collision.

In addition, PA11 has high heat resistance and high resistance to calcium chloride. Thus, the ferrite clamp 1 can be placed outside the vehicle chamber. Further, PA11 is a polyamide-based resin as with PA66, and does not require a special mold structure. Thus, the ferrite clamp 1 can be manufactured by the same mold as that of PA66.
(3) The ferrite clamp 1 includes a pair of electric-wire fixing portions 29. By tightly binding the pair of electric-wire fixing portions 29 sandwiching the electric wire 101 with the binding band B or a tape, for example, the ferrite clamp 1 can be fixed easily and firmly to the electric wire 101. In addition, the ferrite clamp 1 can be attached or detached with the electric-wire fixing portion held by hand, thereby improving workability.

The present invention is not limited to the foregoing example. As a matter of the course, the present invention can be carried out in various modes without departing from the present invention.

For example, the protrusion pieces 23 may have another shape. For example, the arrowhead-shaped falling inhibition portions 23a may be provided at both right and left ends (both right and left ends in Fig. 7) of the protrusion pieces 23.

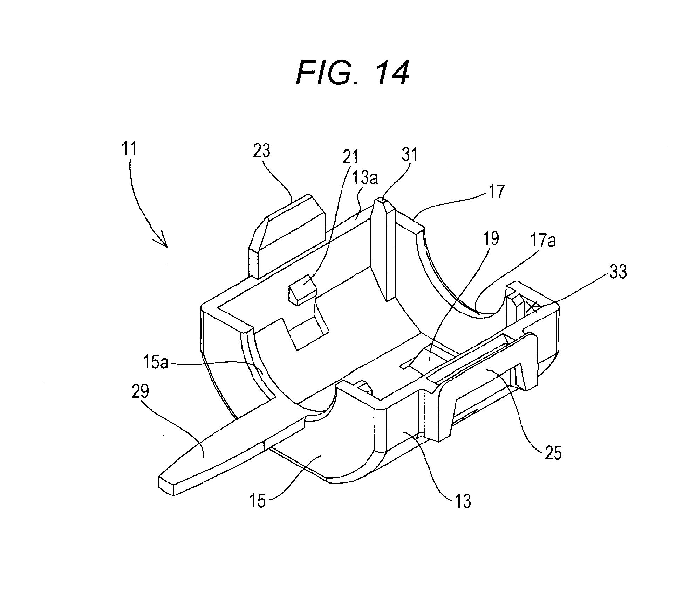

In the foregoing example, the holding piece 31 is disposed at the end portion 13a of the side wall 15 and the end portion 13a of the side wall 17. In a modification example of the invention of the subject application, as illustrated in Fig. 14, the holding piece 31 may be disposed only at the end portion 13a of the side wall 17 opposite to the side wall 15 on which the electric-wire fixing portion 29 is extended.

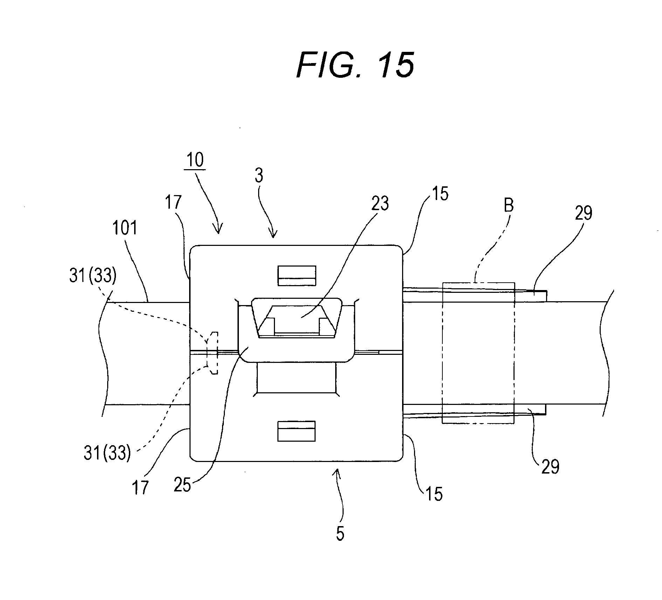

In this case, the holding piece 31 and the holding piece engagement portion 33 are also disposed on the other side wall 17 opposite to the one side wall 15 on which the electric-wire fixing portion 29 is extended. Thus, if any force acts such that the electric-wire fixing portion 29 of the storage portion 3 and the electric-wire fixing portion 29 of the storage portion 5 come closer to each other at a distance shorter than the diameter of the electric wire 101, it is possible to inhibit separation of the storage portion 3 and the storage portion 5 as illustrated in Fig. 15.

Therefore, in this case, at a ferrite clamp 10, joint surfaces 107 of a pair of ferrite pieces 103 stored in the storage portion 3 and stored in the storage portion 5 do not separate from each other. Thus, the two ferrite pieces 103 constantly form and maintain a closed magnetic path, thereby achieving the noise absorbing effect.

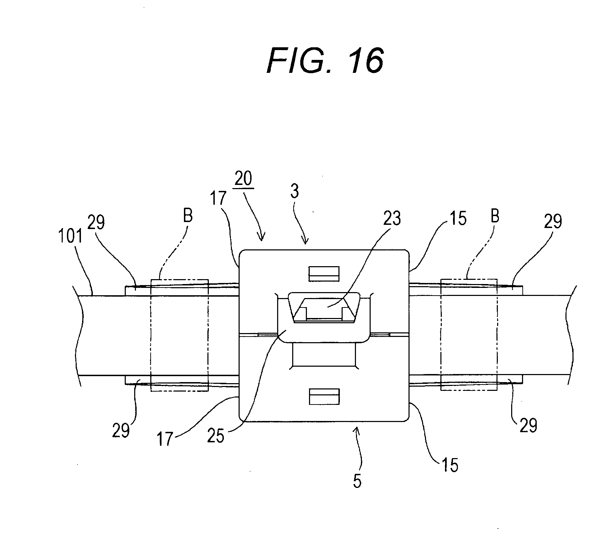

In still another modification example, as illustrated in Fig. 16, the electric-wire fixing portions 29 may be extended to the both side walls 15 and 17 in a ferrite clamp 20.

In this case, the joint surfaces 107 of the ferrite pieces 103 stored in the pair of storage portions 3 and 5 are also inhibited from being separated from each other. Thus, the noise absorbing effect can be achieved.

In the case of the ferrite clamp 20 illustrated in Fig. 16, the electric-wire fixing portions 29 and 29 extending outward from the pair of storage portions 3 and 5 are disposed on the both side walls 15 and 17.

Therefore, as compared to the ferrite clamp 1 in the example and the ferrite clamp 10 in the modification example, the ferrite clamp 20 has a longer portion of the electric wire 101 restricted in motion. When a ferrite clamp is to be positioned in a narrow place, therefore, the ferrite clamp 1 or 10 may be more preferred.

In the foregoing example, modification example, and another modification example, the electric-wire fixing portion 29 is disposed at the center of the peripheral edge of the cut-out 15a (17a). However, the present invention is not limited to this. The electric-wire fixing portion 29 may be respectively disposed at a position appropriately moved from the center of the peripheral edge of the cut-out 15a or 17a.

By the foregoing configuration, the positional relationship among the protrusion pieces 23, the engagement members 25, and the electric-wire fixing portions 29 in the state in which the absorber is closed is different from those in the foregoing example and modification example.

Hence, by manufacturing the ferrite clamp with the positional relationship determined depending on the use status or placement space of the ferrite clamp or the like, it is possible to reliably fix the electric wire 101 to the ferrite clamp and preferably engage the pair of storage portions 3 and 5.

In the foregoing example and modification examples, the electric wire 101 is used as a subject to be inserted into the ferrite pieces 103 to obtain the noise absorbing effect. However, the present invention is not limited to this. The present invention can be applied to any subject that flows electricity and signals and possibly propagates noise (noise current).

## Claims

1. A ferrite clamp, comprising:
a storage case capable of storing a magnetic body and including a pair of separable storage portions; and
a pair of electric-wire insertion holes formed in one side surface and the other side surface of the storage case respectively, wherein
each of the pair of storage portions includes a protrusion piece and a concave portion,
the protrusion piece and concave portion are positioned such that, when the pair of storage portions are assembled together, the protrusion piece disposed in one of the storage portions is fitted into the concave portion formed in the other storage portion, and the protrusion piece disposed in the other storage portion is fitted into the concave portion formed in the one storage portion.

2. The ferrite clamp according to claim 1, wherein the protrusion piece has an arrowhead-shaped falling inhibition portion to inhibit the protrusion piece from falling off from the concave portion.

3. The ferrite clamp according to claim 2, wherein each of the pair of storage portions has a lock portion to lock the falling inhibition portion of the protrusion piece fitted into the concave portion.

4. The ferrite clamp according to any one of claims 1 to 3, wherein
each of the pair of storage portions has at least one side wall defining the one side surface or the other side surface, and
each of the pair of storage portions includes electric-wire fixing portion extending outward from at least one side wall of each of the pair of storage portions in an axial direction of the pair of electric-wire insertion holes.

5. The ferrite clamp according to claim 4, wherein the side wall is provided with a holding piece to hold the pair of storage portions in closed state.

6. The ferrite clamp according to any one of claims 1 to 3, wherein
each of the pair of storage portions has a first side wall defining the one side wall and a second side wall defining the other side surface, and
each of the pair of storage portions includes electric-wire fixing portion extending outward from at least one of the first side wall and the second side wall of each of the pair of storage portions in the axial direction of the pair of electric-wire insertion holes.

7. The ferrite clamp according to claim 6, wherein a holding piece for holding the pair of storage portions in closed state is disposed on the side wall opposite to the one side wall of the first side wall and the second side wall provided with the electric-wire fixing portion.

8. The ferrite clamp according to claim 6, wherein
the electric-wire fixing portion is disposed on each of the first side wall and the second side wall in each of the pair of storage portions, and
a holding piece for holding the pair of storage portions in closed state is disposed on each of the first side wall and the second side wall.

9. The ferrite clamp according to any one of claims 1 to 3, wherein the storage case is made of PA11.
